Europäisches Patentamt

European Patent Office

Office européen des brevets

(11) Veröffentlichungsnummer: **0 262 438 B1**

# EUROPÄISCHE PATENTSCHRIFT

(45) Veröffentlichungstag der Patentschrift: **02.12.92**

(21) Anmeldenummer: **87112825.2**

(22) Anmeldetag: **02.09.87**

(51) Int. Cl.5: **H01S 3/085**, G02B 6/28, H04B 10/04

(54) Lasersender mit einem Halbleiterlaser und einem externen optischen Resonator in Form eines frequenzselektiven Faserrichtkopplers.

(30) Priorität: **29.09.86 DE 3633077**

(43) Veröffentlichungstag der Anmeldung:
**06.04.88 Patentblatt 88/14**

(45) Bekanntmachung des Hinweises auf die
Patenterteilung:
**02.12.92 Patentblatt 92/49**

(84) Benannte Vertragsstaaten:
**AT BE CH DE ES FR GB GR IT LI NL SE**

(56) Entgegenhaltungen:
**EP-A- 0 182 033**

**SIEMENS FORSCHUNGS- UND ENTWICK-LUNGSBERICHTE, Band 15, Nr. 1, 1986, Seiten 32-39, Springer-Verlag, Berlin, DE; G. BÖCK: "Wellenlängenselektiver koaxialer Lichtwellenleiter-Richtkoppler"**

**ELECTRONICS LETTERS, Band 22, Nr. 18, 28. August 1986, Seiten 965-966, Stevenage, Herts, GB; G. BOECK: "New type of fibre-optic ring resonator"**

(73) Patentinhaber: **SIEMENS AKTIENGESELL-SCHAFT
Wittelsbacherplatz 2
W-8000 München 2(DE)**

(72) Erfinder: **Häussler, Klaus-M, Dr.
Hildebrandstrasse 13
W-8000 München 19(DE)**
Erfinder: **Wittmann, Julius, Dipl.-Ing.
Innerer Stockweg 7
W-8024 Oberhaching(DE)**
Erfinder: **Gaukel, Gisela, Dipl.-Phys.
Görresstrasse 17
W-8000 München 40(DE)**
Erfinder: **Auracher, Franz, Dr.
Eichenstrasse 26
W-8021 Baierbrunn(DE)**

**Beschreibung**

Die vorliegende Erfindung betrifft einen Lasersender mit einem Halbleiterlaser und einem externen Resonator in Form eines frequenzselektiven Faserrichtkopplers bei dem die Ausgangsleistung aus dem Resonator, der eine Wellenlängenselektivität des Senders bewirkt, entnommen wird.

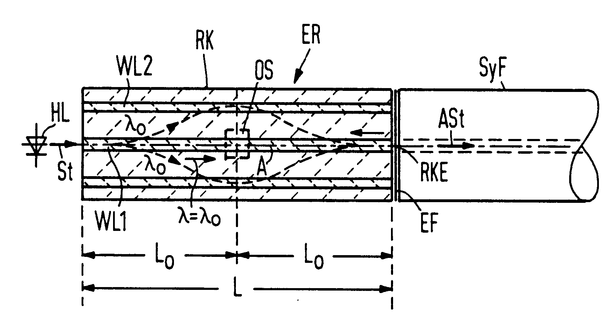

Ein Sender der genannten Art ist in der nicht vorveröffentlichten EP-A-0 216 212 mit älterem Zeitrang vorgeschlagen (siehe dort Figur 2 und dazugehörigen Beschreibungsteil). Dieser Stand der Technik (Artikel 54(3) EPÜ) ist für die Frage der erfinderischen Tätigkeit nicht von Bedeutung.

Bei diesem vorgeschlagenen Sender wird die von dem Halbleiterlaser in den einen Wellenleiter eingekoppelte Strahlungsleistung der teildurchlässigen Rückkopplungseinrichtung zugeleitet und der von der Rückkopplungseinrichtung durchgelassene Teil der Strahlungsleistung wird über einen schleifenförmigen optischen Wellenleiter dem anderen optischen Wellenleiter zugeleitet, an dem die diesen Teil enthaltende Ausgangsleistung des Senders entnommen wird.

Mit einem derartigen Lasersender kann ein extrem schmalbandiger, einmodiger Betriebszustand erreicht werden, wie er für zukünftige faseroptische Nachrichtenssysteme, insbesondere mit Heterodyn- und Homodynempfang erforderlich ist.

Ein derartiger Lasersender weist den Vorteil auf, daß die Ankopplung des Resonators und einer Systemfaser an den Halbleiterlaser auf nur einer Seite des Halbleiterlasers erfolgt, in Gegensatz zu anderen Ausführungsform solcher Lasersender, bei denen die Systemfaser auf einer Seite und der Resonator auf der gegenüberliegenden Seite an den Halbleiterlaser angekoppelt sind. Durch die einseitige Ankopplung werden Justierprobleme erheblich vermindert und es kann dem Erfordernis einer hohen mechanischen Stabilität bei der Ankopplung der Systemfaser und des externen Resonators besser entsprochen werden.

Aus der EP-A-0 182 033 ist ein Lasersender mit einem Halbleiterlaser und einem externen optischen Resonator in Form eines wellenlängenselektiven Faserrichtkopplers bekannt. Dieser Richtkoppler weist zwei optische Wellenleiter auf, längs denen eine wellenlängenselektive Überkopplung erfolgt. Der Halbleiterlaser ist an einen Wellenleiter angekoppelt, der an einem von dem Halbleiterlaser fernen Ende in einen optischen Sumpf mündet. Der andere Wellenleiter ist an einem von dem Halbleiterlaser fernen Ende durch einen Spiegel abgeschlossen, der das zugeführte Licht in den anderen Wellenleiter zurückreflektiert. Dieser Faserrichtkoppler kann aus einer dispersiven Doppelkernfaser bestehen, wobei ein Kern den einen an den Halbleiterlaser angekoppelten Wellenleiter und der andere Kern den anderen Wellenleiter bildet. In Bezug auf eine Verwendung eines von einer Rückkopplungseinrichtung durchgelassenen Teils einer im Richtkoppler zugeleiteten Strahlungsleistung für eine Ausgangsleistung des Senders ist der EP-A 0 182 033 nichts zu entnehmen.

Aufgabe der Erfindung ist es, einen besonders kompakt gestalteten schmalbandigen Sender der eingangs genannten Art mit einseitiger Ankopplung anzugeben, der keinen schleifenförmigen optischen Wellenleiter benötigt.

Diese Aufgabe wird durch die im Patentanspruch 1 angegebenen Merkmale gelöst.

Als dort genannte dispersive Doppelkernfasern sind beispielsweise Fasern geeignet, wie sie in der EP-A-0 182 033 beschrieben sind. Solche Fasern wirken als stark dispersiver Resonator. Besonders hervorzuheben sind bei einem derartigen Resonator die Unempfindlichkeit des Resonators bzw. seiner dispersiven Eigenschaften gegen thermische und mechanische Einflüsse, die nur durch Strukturparameter der Doppelkernfaser bestimmt werden, sowie die einfache Einkopplung in eine anschließende Systemfaser.

Bevorzugte Ausgestaltungen des erfindungsgemäßen Lasersenders gehen aus den Ansprüchen 2 und 3 hervor.

Die Erfindung wird anhand der Figur in der folgenden Beschreibung beispielhaft beschrieben.

Die Figur zeigt den beispielhaften Lasersender mit der Doppelkernfaser und einer daran angekoppelten Systemfaser, wobei die Doppelkernfaser im axialen Längsschnitt dargestellt ist.

Bei dem dargestellten Beispiel des Lasersenders LS besteht der wellenlängenselektive Faserrichtkoppler RK des externen Resonators ER aus einer dispersiven Doppelkernfaser mit rotationssymmetrischem Aufbau. Den an den Halbleiterlaser HL angekoppelten optischen Wellenleiter WL1 bildet der zentrale Kern dieser Faser, der längs der Achse A dieser Faser verläuft. Der andere optische Wellenleiter WL2 ist durch einen koaxialen, den einen Kern WL1 mit Abstand ummantelnden Kern gegeben.

Prinzipiell ist jedoch jede dispersive Doppelkernfaser, beispielsweise jede aus der EP-A-0 182 033 bekannte Doppelkernfaser geeignet.

Die der Koppelstrecke L des Faserrichtkopplers RK entsprechende Länge der Doppelkernfaser ist gleich einem ganzzahligen Vielfachen, speziell der doppelten Überkopplungslänge $L_0$ gewählt, bei der eine an einem Ende der Doppelkernfaser in einen der beiden Wellenleiter WL1 oder WL2 eingekoppelte Strahlungsleistung St vollständig in den anderen Wellenleiter WL2 bzw. WL1 übergekoppelt ist. Demnach ist eine an einem Ende der Doppelkernfaser in den einen Wellenleiter WL1 eingekoppelte Strahlungsleistung St in der längsaxialen Mitte der Doppelkernfaser vollständig in den anderen Wellenleiter WL2 übergekoppelt, während am anderen Ende der Faser diese Strahlungsleistung wieder vollständig auf den einen Wellenleiter WL1 übergekoppelt ist.

Übergekoppelt wird dabei wird dabei nur eine Strahlungsleistung einer gewünschten Wellenlänge $\lambda_0$. Strahlungsleistung mit einer von der gewünschten Wellenlänge $\lambda_0$ verschiedenen Wellenlänge $\lambda$ wird ohne Überkopplung längs des einen Wellenleiters WL1 vom einen zum anderen Ende der Doppelkernfaser überführt. Dieser eine Wellenleiter WL1 wird nach der einfachen Überkopplungslänge $L_0$, also in der längsaxialen Mitte der Doppelkernfaser, bei welcher Strahlungsleistung der Wellenlänge $\lambda_0$ von dem einen Wellenleiter WL1 vollständig in den anderen Wellenleiter WL2 übergekoppelt ist, durch einen optischen Sumpf OS unterbrochen, so daß Strahlungsleistung mit einer von der Wellenlänge $\lambda_0$ verschiedenen Wellenlänge $\lambda$ nicht zu dem von dem Halbleiterlaser HL abgekehrten Ende EF der Doppelkernfaser gelangen kann, sondern im wesentlichen nur Strahlungsleistung der Wellenlänge $\lambda_0$.

An diesem anderen Ende EF der Doppelkernfaser ist die teildurchlässige Rückkopplungseinrichtung RKE im Bereich des einen Wellenleiters WL1 beispielsweise in Form einer teildurchlässigen Spiegelschicht vorgesehen.

Der durch die Rückkopplungseinrichtung RKE hindurchgegangene teil der Strahlungsleistung mit der Wellenlänge $\lambda_0$ wird in den Kern einer an die Doppelkernfaser beispielsweise stoßgekoppelte Systemfaser SyF eingekoppelt und fortgeleitet.

Wird eine Doppelkernfaser mit nur der einfachen Überkopplungslänge $L_0$ oder einem ungeradzahligen Vielfachen davon verwendet, ist die Rückkopplungseinrichtung an dem von dem Halbleiterlaser abgekehrten Ende der Doppelkernfaser im Bereich des nicht an den Halbleiterlaser angekoppelten Wellenleiters vorzusehen und die Systemfaser ist an diesen Wellenleiter anzukoppeln, Ein optischer Sumpf ist hier im allgemeinen nicht erforderlich, könnte aber beispielsweise an dem von dem Halbleiterlaser abgekehrten Ende der Faser im Bereich des an diesen Laser angekoppelten Wellenleiters vorgesehen sein.

Generell gilt, daß die Überkopplungslänge $L_0$ die Wellenlänge $\lambda_0$ der reflektierten Strahlung, die Bandbreite und damit die Selektivität des Resonators nur von den Strukturparametern der Doppelkernfaser bestimmt werden.

Durch die Rückkopplung eines Teils der vom Halbleiterlaser HL ausgestrahlten Leistung wird ein einmodiger Betrieb des Lasersenders mit schmaler Linienbreite erzwungen. Da die Linienbreite des sich ergebenden Einmodenspektrums der Länge des externen Resonators umgekehrt proportional ist (siehe dazu IEEE Journ. of Quant. Electronics QE-20 (1984) S. 486ff) kann zur Erzielung einer kleineren Linienbreite eine Doppelkernfaser mit einer Länge verwendet werden, die ein Vielfaches der Überkopplungslänge $L_0$ beträgt.

Es ist zweckmäßig, die von dem externen Resonator ER abgekehrte Seite des Halbleiterkörpers zu verspiegel. Dadurch steigt die optische Leistung bei gleichem Pumpsystem aufgrund der Schwellstromerniedrigung und die Empfindlichkeit bezüglich parasitärer Reflexionen sinkt. Dies gilt für alle Lasersender mit externem Resonator und einseitiger Ankopplung, d.h. bei denen die Ausgangsleistung des Senders auf der Seite des Resonators entnommen wird.

## Patentansprüche

1. Lasersender (LS) mit einem Halbleiterlaser (HL) und einem externen optischen Resonator (ER) in Form eines wellenlängenselektiven Faserrichtkopplers (RK), der aus zwei in einer bestimmten Koppelstrecke (L) in derart geringem Abstand nebeneinander verlaufenden Wellenleitern (WL1, WL2) besteht, daß in der Koppelstrecke (L) eine Leistungsüberkopplung zwischen den Wellenleitern (WL1, WL2) auftritt, wobei einer (WL1) der beiden Wellenleiter (WL1, WL2) an den Halbleiterlaser (HL) angekoppelt ist, wobei eine teildurchlässige Rückkopplungseinrichtung (RKE) vorgesehen ist, die eine aus der Koppelstrecke (L) zugeleitete Strahlungsleistung teilweise durchläßt und teilweise in die Koppelstrecke zurückleitet, und wobei ein von der Rückkopplungseinrichtung (RKE) durchgelassener Teil der zugeleiteten Strahlungsleistung für eine Ausgangsleistung (ASt) des Senders (LS) verwendet ist, wobei der frequenzselektive Faserrichtkoppler (RK) aus einer dispersiven Doppelkernfaser besteht, wobei ein Kern den einen an den Halbleiterlaser (HL) angekoppelten Wellenleiter (WL1) und der andere Kern den anderen Wellenleiter (WL2) bildet, und der Rückkopplungseinrichtung (RKE) eine in der Koppelstrecke (L) wenigstens einmal von dem einen Wellenleiter (WL1) in den anderen Wellenleiter (WL2) übergekoppelte Strahlungsleistung zugeleitet ist, und der von der Rückkopplungseinrichtung (RKE) durchgelassene Teil dieser übergekoppelten Strahlungsleistung die Ausgangsleistung (ASt) des Senders (LS) bildet.

2. Sender nach Anspruch 1, **dadurch gekennzeichnet,** daß die Koppelstrecke (L) so groß gewählt ist, daß die von dem einen Wellenleiter (WL1) in den anderen Wellenleiter (WL2) übergekoppelte Strahlungsleistung an dem von dem Halbleiterlaser (HL) abgekehrten Ende der Doppelkernfaser wieder vollständig in den einen Wellenleiter (WL1) übergekoppelt ist, daß an diesem Ende (EF) der Doppelkernfaser die Rückkopplungseinrichtung (RKE) zumindest im Bereich des einen Wellenleiters (WL1) vorgesehen ist, und daß im Inneren der Doppelkernfaser ein den einen Wellenleiter (WL1) unterbrechender optischer Sumpf (OS) vorgesehen ist.

3.  Sender nach Anspruch 1 oder 2, **dadurch gekennzeichnet**, daß der andere Wellenter (WL2) den einen Wellenleiter (WL1) mantelförmig umgibt.

## Claims

1.  Laser transmitter (LS) having a semiconductor laser (HL) and an external optical resonator (ER) in the form of a wavelength-selective fibre directional coupler (RK), which consists of two waveguides (WL1, WL2) which extend in a defined coupling length (L) at such a small spacing beside one another that in the coupling length (L) a coupling-over of power takes place between the waveguides (WL1, WL2), one (WL1) of the two waveguides (WL1, WL2) being coupled onto the semiconductor laser (HL), a partially transmitting feedback device (RKE) being provided, which partially transmits and partially returns into the coupling length a radiant power fed in from the coupling length (L) and a part of the radiant power fed in, said part being transmitted by the feedback device (RKE), being employed for an output power (ASt) of the transmitter (LS), the frequency-selective fibre directional coupler (RK) consisting of a dispersive double core fibre, one core forming one of the waveguides (WL1) coupled onto the semiconductor laser (HL) and the other core forming the other waveguide (WL2), and a radiant power coupled over in the coupling length (L) at least once from the one waveguide (WL1) into the other waveguide (WL2) being fed into the feedback device (RKE), and that part of this radiant power coupled over which is transmitted by the feedback device (RKE) forming the output power (ASt) of the transmitter (LS).

2.  Transmitter according to Claim 1, characterised in that the coupling length (L) is selected to be of such magnitude that the radiant power coupled over from the one waveguide (WL1) into the other waveguide (WL2) is coupled over again completely into the one waveguide (WL1) at the end of the double core fibre remote from the semiconductor laser (HL), in that at this end (EF) of the double core fibre the feedback device (RKE) is provided at least in the region of the one waveguide (WL1), and in that an optical sump (OS) interrupting the one waveguide (WL1) is provided in the interior of the double core fibre.

3.  Transmitter according to Claim 1 or 2, characterised in that the other waveguide (WL2) surrounds the one waveguide (WL1) in the manner of an envelope.

## Revendications

1.  Émetteur laser (LS) comportant un laser à semiconducteurs (HL) et un résonateur optique externe (ER) se présentant sous la forme d'un coupleur directionnel (RK) de fibres, qui est sélectif du point de vue des longueurs d'ondes et qui est constitué par deux guides d'ondes (WL1, WL2), qui s'étendent côte-à-côte, sur une section déterminée de couplage (L), à une faible distance telle que dans la section de couplage (L), il apparaît un surcouplage de puissance entre les guides d'ondes (WL1, WL2), et dans lequel l'un (WL1) des deux guides d'ondes (WL1, WL2) est accouplé au laser à semiconducteurs (HL), alors qu'il est prévu un dispositif de réaction partiellement transparent (RKE), qui transmet partiellement une puissance de rayonnement délivrée par la section de couplage (L) et la renvoie partiellement dans cette section de couplage, et une partie, transmise par le dispositif de réaction (RKE), de la puissance de rayonnement envoyée est utilisée en tant que puissance de sortie (ASt) de l'émetteur (LS), que le coupleur directionnel (RK) de fibres, qui est sélectif du point de vue des fréquences, est constitué par une fibre dispersive à noyau double, un noyau constituant un guide d'ondes (WL1) accouplé au laser à semiconducteurs (HL) et l'autre noyau formant l'autre guide d'ondes (WL2), et qu'une puissance de rayonnement, surcouplée dans la section de couplage (L), au moins une fois par un guide d'ondes (WL1) dans l'autre guide d'ondes (WL2), est envoyée au dispositif de réaction (RKE), la partie qui est transmise par le dispositif de réaction (RKE), de cette puissance de rayonnement surcouplée constituant la puissance de sortie (ASt) de l'émetteur (LS).

2.  Émetteur suivant la revendication 1, caractérisé par le fait que la section de couplage (L) est choisie suffisamment grande pour que la puissance de rayonnement transmise par surcouplage d'un guide d'ondes (WL1) dans l'autre guide d'ondes (WL2) soit transmise à nouveau complètement par surcouplage au premier guide d'ondes (WL1), à l'extrémité, tournée à l'opposé du laser à semiconducteurs (HL1), de la fibre à double noyau, qu'à cette extrémité (EF) de la fibre à double noyau, le dispositif de réaction (RKE) est disposé au moins dans la zone du premier guide d'ondes (WL1), et qu'un puits optique (OS), qui interrompt un premier guide d'ondes (WL1), est prévu à l'intérieur de la fibre à double noyau.

3. Émetteur suivant la revendication 1 ou 2, caractérisé par le fait que l'autre guide d'ondes (WL2) entoure, à la manière d'une gaine, le premier guide d'ondes (WL1).